# EUROPÄISCHE PATENTSCHRIFT

(11) **EP 0 958 241 B1**
(45) Veröffentlichungstag und Bekanntmachung des Hinweises auf die Patenterteilung: **30.05.2001**
(21) Anmeldenummer: 97932730.1
(22) Anmeldetag: 27.06.1997
(51) Int. Cl.: C01B 31/02

(54) **VERFAHREN UND VORRICHTUNG ZUR HERSTELLUNG VON STABILEN ENDOHEDRALEN FULLERENEN DER STRUKTUR Z-at-Cx MIT x GRÖSSER GLEICH 60**
PROCESS AND DEVICE FOR PRODUCING STABLE ENDOHEDRAL FULLERENES OF STRUCTURE Z-at-Cx WITH x GREATER THAN OR EQUAL TO 60
PROCEDE ET DISPOSITIF DE PRODUCTION DE FULLERENES ENDOEDRES STABLES DE STRUCTURE Z-at-Cx AVEC x SUPERIEUR OU EGAL A 60

(30) Priorität: 28.06.1996 DE 19627337
(43) Veröffentlichungstag der Anmeldung: 24.11.1999
(73) Patentinhaber: Hahn-Meitner-Institut Berlin Gesellschaft mit beschränkter Haftung, 14109 Berlin (DE)
(72) Erfinder: WEIDINGER, Alois, D-14163 Berlin (DE); ALMEIDA MURPHY, Theo, D-40668 Meerbusch (DE); MERTESACKER, Bernd, D-12165 Berlin (DE); HÖHNE, Manfred, D-12489 Berlin (DE); PAWLIK, Thomas, D-33175 Bad Lippspringe (DE); SPAETH, Johann-Martin, D-33100 Paderborn (DE); PIETZAK, Björn, D-12689 Berlin (DE)
(74) Vertreter: Rudolph, Margit
(86) Internationale Anmeldenummer: DE9701399
(87) Internationale Veröffentlichungsnummer: WO9800363

(56) Entgegenhaltungen:
- EP-A- 0 726 228
- US-A- 5 300 203
- T. ALMEIDA MURPHY ET AL.: "Nitrogen inside C60" FULLERENES FULLERENE NANOSTRUCT., PROC. INT. WINTERSCH. ELECTRON. PROP. NOVEL MATER., 10TH (1996), EDITOR: KUZMANY H., PUBLISHER: WORLD SCIENTIFIC, SINGAPORE, 2. - 9.März 1996, Seiten 191-195, XP002045790
- MORAN-LOPEZ J L ET AL: "A POSSIBLE ROUTE TO MACROSCOPIC FORMATION OF ENDOHEDRAL FULLERENES" SOLID STATE COMMUNICATIONS, Bd. 96, Nr. 7, 1.Januar 1995, Seiten 451-457, XP000569486
- SAUNDERS M ET AL: "Stable compounds of helium and neon: He C/sub 60/ and Ne C/sub 60/" SCIENCE, 5 MARCH 1993, USA, Bd. 259, Nr. 5100, ISSN 0036-8075, Seiten 1428-1430, XP002045820 in der Anmeldung erwähnt

## Beschreibung

Die Erfindung betrifft ein Verfahren zur Herstellung von stabilen endohedralen Fullerenen der Struktur Z@Cₓ mit x ≥ 60, wobei ein Z-Atom in das Fulleren implantiert wird, indem gleichzeitig in einem Gefäß sowohl Fullerene als auch niederenergetische beschleunigte Z-Teilchen bereitgestellt werden und miteinander wechselwirken, dann diese Fullerene aus dem Gefäß entfernt, in Lösungsmittel gelöst und getrocknet werden. sowie eine Vorrichtung zur Durchführung des Verfahrens.

Fullerene sind Kohlenstoff-Cluster, die in Abhängigkeit von der in ihnen enthaltenen Anzahl von C-Sechsecken neben den immer vorhandenen zwölf C-Fünfecken, verschiedene räumliche Anordnungen bilden. Die ideale Anordnung der Fünfecke und damit die höchste Symmetrie und Stabilität hat das C₆₀-Fulleren, das sogenannte Buckminster-Fulleren. Die Kohlenstoff-Moleküle dieses Fullerens umschließen einen 0.7 nm großen Hohlraum. Damit bietet sich die Möglichkeit, in diesem Hohlraum andere Elemente anzuordnen, um gezielt die Eigenschaften des C₆₀-Fullerens zu verändern.

So ist die Herstellung endohedraler Fulleren-Metallkomplexe, die mit dem Symbol M@Cₓ gekennzeichnet werden, mehrmals von Smalley et al. (beispielsweise in J. Phys. Chem. 1991, 95, 7564 bis 7568) beschrieben worden. Mittels Laserverdampfung von dotiertem Graphit werden metallhaltige Fullerene des Typs M@C₆₀ (M = La, Ni, Na, K, Rb, Cs) und La@Cₓ (x =60, 70, 74, 82) hergestellt, die genannten Metalle befinden sich in der Käfigstruktur.

In Angew. Chem. 104 (1992) Nr.2, S. 242 bis 244 wird darüber berichtet, daß auch die Edelgasatome He und Ne in C₆₀- und C₇₀-Fullerene durch Atomkollision eingebaut werden, wenn hochbeschleunigte Cₓ-lonen in einem Molekularstrahlexperiment durch eine stationäre Edelgasatmosphäre geschossen werden.

Auch in SCIENCE VOL. 259 5 March 1993, 1428 bis 1430 wird die Herstellung von stabilen He@C₆₀ und Ne@C₆₀ - hier mittels Verdampfens von Graphit im elektrischen Lichtbogen in He-Atmosphäre oder durch Tempern von C₆₀ bei hohen Temperaturen und hohen Drücken - beschrieben.

In "Proceedings of the Symposium on RECENT ADVANCES IN THE CHEMISTRY AND PHYSICS OF FULLERENES AND RELATED MATERIALS", Vol. 3, Proceedings Volume 96-10, The Electrochemical Society, S. 578 bis 585 wird über ein Verfahren zur Herstellung von dünnen Schichten von C₆₀, in denen bis zu 30% der Fullerene ein Alkali-lon enthalten, berichtet. Diese Alkalilonen enthaltenden C₆₀-Fullerene werden dadurch erzeugt, daß zunächst auf einem Substrat ein C₆₀-Film einer geforderten Dicke aufgebracht. dann in den lonenstrahl bewegt und mit Alkali-lonen einer Energie von einigen eV bis einigen Hundert eV beschossen wird. Danach wird dieses Substrat aus dem lonenstrahl bewegt, ein weiterer C₆₀-Film aufgebracht, im lonenstrahl positioniert, mit Alkali-lonen beschossen usw. Auf diese Weise wird eine Schicht von einigen Hundert Nanometern Dicke hergestellt, die - wie bereits erwähnt - bis zu 30% endohedrale Alkali-Fullerene enthalten. Alkali-Metalle sind Elemente der 1. Hauptgruppe des Periodensystems der Elemente und bilden positive Ionen. Das Alkali-lon gibt ein Elektron an den es umschließenden C₆₀-Käfig ab, wodurch der gebildete endohedrale Fulleren-Komplex sehr reaktiv ist und sich seine Weiterverarbeitung - wie eine Trennung von den nicht gewünschten Fullerenen - wegen seiner chemischen Instabilität sehr schwierig gestaltet.

Alle vorstehend angegebenen bekannten Lösungen ermöglichten jedoch nicht für alle Elemente, die in die Käfigstruktur der Cₓ-Fullerene eingebaut werden sollten, die Herstellung von - für ihre spätere Weiterbearbeitung - stabilen endohedralen Cₓ-Fullerenen mit x ≥ 60.

Aus T. Almeida Murphy et al. "Nitrogen inside C₆₀" Fullerenes and Fullerene Nanostruct., Proc. Int. Wintersch. Elektron. Prop. Novel Mater., 10TH (1996), Editor: Kuzmany H., Publisher: World Scientific, Singapore, 2. bis 9. März 1996, Seiten 191 bis 195, XP002045790 ist ein Verfahren zur Herstellung endohedraler Fullerene bekannt, bei dem mit Hilfe einer lonenquelle Stickstoff in C₆₀-Fullerene implantiert wird. Nachteilig ist hierbei, daß die Bereitstellung einer separaten lonenquelle und der erforderlichen Hochvakuumanlage einen sehr hohen technischen Aufwand bedingt.

Deshalb ist es Aufgabe der Erfindung, ein ohne großenteilmischen Aufwand realisierbare Verfahren zur Herstellung von stabilen endohedralen Fullerenen der Struktur Z@Cₓ mit x ≥ 60, insbesondere mit x = 60, aber auch mit x = 70, 76, 78 und 84, sowie eine Vorrichtung hierzu anzugeben, wobei zunächst ein Z-Atom in das Fulleren implantiert werden soll indem gleichzeitig in einem Vakuumgefäß sowohl Fullerene als auch niederenergetische beschleunigte Z-Teilchen bereitgestellt werden und miteinander wechselwirken, dann diese Fullerene aus dem Vakuumgefäß entfernt, in Lösungsmittel gelöst und getrocknet werden.

Die Aufgabe wird erfindungsgemäß dadurch gelöst, daß die Bereitstellung der Fullerene durch Verdampfen von Cₓ in einem von einem das zu implantierende Material enthaltenden Gasgemisch durchströmten Ofen und die Bereitstellung der beschleunigten Z-Teilchen durch eine Hochspannungs-Gasentladung in demselben Ofen erfolgen.

Als Z-Atome werden bei dem erfindungsgemäßen Verfahren Atome der Nichtmetalle oder der Halbmetalle implantiert, insbesondere C, N, P, O, S, B, Si, Ge und As.

Die in die Fullerene Cₓ zu implantierenden Materialien Z werden als gasförmige Verbindungen der betreffenden Atome, beispielsweise BF₃, CH₄, SiH₄, H₂S, GeH₄, AsH₃, N₂ und O₂, in das Gasentladungsrohr eingebracht.

Bei dem erfindungsgemäßen Verfahren wird das reaktive Z-Atom durch die Käfigstruktur des Fullerens, das wie eine Schutzhülle für das Z-Atom wirkt, stabilisiert.

Die in die Käfigstruktur der Cₓ-Fullerene mit x ≥ 60 eingebrachten Z-Atome der Nicht- oder Halbmetalle behalten ihre atomare Elektronenhülle weitgehend. Daraus resultiert bei den mit dem erfindungsgemäßen Verfahren hergestellten endohedralen Fullerenverbindungen ihre Stabilität in organischen Lösungsmitteln und an Luft. Damit können die gewünschten endohedralen Fullerene aus dem entstehenden Fullerengemisch abgetrennt und ihrer praktischen Verwertung zugeführt werden.

Die erfindungsgemäße Lösung gestattet durch die gleichzeitige Bereitstellung der miteinander wechselwirkenden Teilchen mittels lonenbeschuß den Einbau einer Vielzahl von Materialien in die Kohlenstoff-Cluster.

Die erfindungsgemäße Vorrichtung zur Herstellung von stabilen endohedralen Fulleren der Struktur Z@Cₓ mit x ≥ 60 mittels einer Hochspannungs-Gasentladung sieht vor, daß in einem Hochspannungs-Gasentladungs-Ofen eine beheizte Quelle zur Bereitstellung der zu implantierenden Fullerene Cₓ, Mittel, die das Durchströmen des Ofens mit einer gasförmigen Verbindung des zu implantierenden Materials Z ermöglichen, sowie Anode und Kathode zur Zündung der Entladung angeordnet sind und die Kathode Mittel zu ihrer Kühlung und/oder eine vergrößerte Fläche aufweist.

In einer Ausführungsform der Erfindung ist die vergrößerte Fläche der Kathode als abwickelbares Band ausgebildet und über einen Kühlfinger geführt, weiterhin sind Mittel zum Aufwickeln des Teiles des Bandes, der mit implantierten Fullerenen der Struktur Z@Cₓ mit x ≥ 60 bedeckt ist, angeordnet. Die Kathode ist mit Wasser oder flüssigem Stickstoff gekühlt.

Mit der erfindungsgemäßen Lösung ist eine Vorrichtung angegeben, die mit einfachen technischen Mitteln eine sehr effiziente Herstellung der endohedralen Fullerene der Struktur Z@Cₓ mit x ≥ 60 gewährleistet, da die großflächige und gekühlte Elektrode einen großen Reaktionsraum und einen gezielten Niederschlag der Fullerene ermöglicht.

Die Verwendung der gemäß der erfindungsgemäßen Lösung hergestellten Z@Cₓ-Fullerene mit x ≥ 60 ist als Sonde in kondensierter Materie, insbesondere als sehr empfindliche Sonde für die Eigenschaftsänderung der Fullerene bei chemischen Reaktionen bzw. als Sonde für den Transport von Fullerenen in biologischen Systemen, bzw. als dotiertes Halbleitermaterial vorgesehen. In den mit dem erfindungsgemäßen Verfahren hergestellten Z@Cₓ-Fullerenen kann deren Cₓ-Hülle beispielsweise durch Erhöhung der Temperatur aufgebrochen werden, so daß z. B. atomarer Stickstoff - im Gegensatz zu bisher üblicherweise entstehendem molekularen Stickstoff - freigesetzt wird.

Weitere Merkmale und zweckmäßige Ausgestaltungsformen der Erfindung ergeben sich aus den folgenden Ausführungsbeispielen zur Herstellung von N@C₆₀-Fullerenen und dazu vorgesehener Vorrichtungen, die anhand der Zeichnungen näher erläutert werden.

Dabei zeigen:
- Fig. 1: eine Vorrichtung zur gleichzeitigen Bereitstellung der Fullerene durch Verdampfen von C₆₀ und der beschleunigten N-Teilchen durch eine Hochspannungs-Gasentladung mit gekühlter Kathode:
- Fig. 2: ein Entladungsrohr, angeordnet in einem Hochspannungs-Entladungs-Ofen gemäß Fig. 1 mit gekühlter Kathode, die eine vergrößerte Fläche aufweist, im Querschnitt:
- Fig. 3: ein ESR-Spektrum von ¹⁴N@C₆₀.

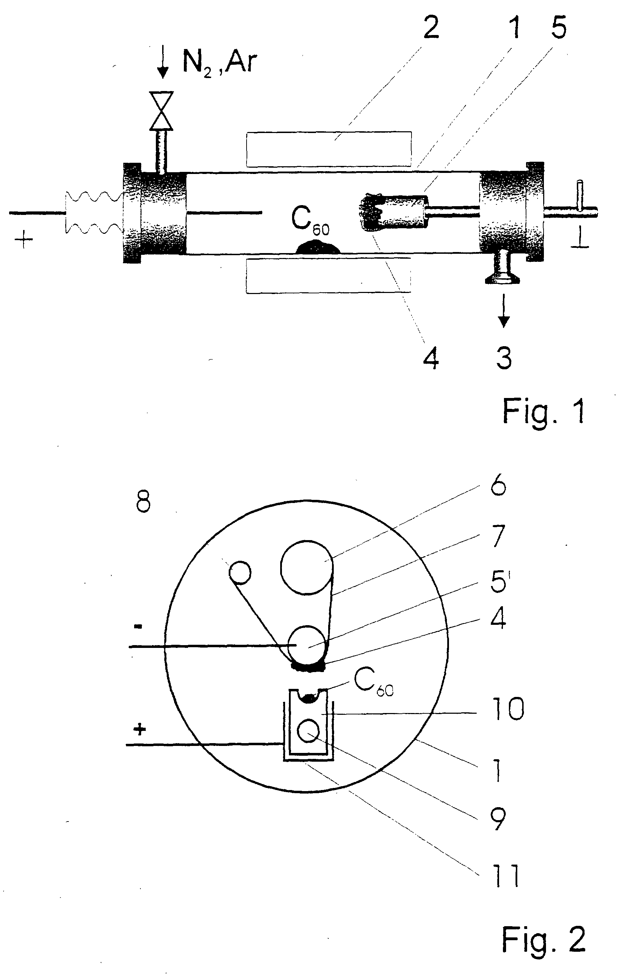

Die in Fig. 1 schematisch dargestellte Vorrichtung zeigt eine Quarzampulle **1**, die sich in einem Ofen 2 befindet. Die Quarzampulle **1** wird auf etwa 500 °C aufgeheizt und von einem durch die Pumpe 3 geförderten N₂-Ar-Gemisch durchströmt. Der Gasdruck in der Quarzampulle **1** wird auf 10⁻³ bis 10 mbar eingestellt. Das in der Quarzampulle **1** angeordnete C₆₀-Material verdampft unter diesen Bedingungen und wird durch die Quarzampulle **1** transportiert. Wird nun gleichzeitig eine Hochspannungs-Gasentladung bei 1 bis 4 kV gezündet, entstehen **N**^{**+**}-lonen, die auch hier wiederum mit den sich in der Quarzampulle **8** befindlichen Fullerenen wechselwirken. Die gebildeten endohedralen Fullerene **4** werden von der gekühlten Kathode **5** entfernt und in Toluol gelöst, gefiltert und in einem N₂-Strom bei Raumtemperatur eingetrocknet. Messungen ergaben, daß etwa 10⁻⁴ Teilchen der aufgedampften C₆₀-Fullerene durch ihre Wechselwirkung mit den N⁺-lonen in endohedrale Fullerene N@C₆₀ umgebildet wurden.

In dem in Fig. 2 dargestellten Querschnitt des in einem Hochspannungs-Gasentladungs-Ofen angeordneten Entladungsrohrs, einer Quarzampulle **1**, ist die Kathode **5'** ebenfalls gekühlt. Außerdem weist die gekühlte Kathode **5'** eine vergrößerte Fläche auf, die durch ein über die Kathode **5'** von einer Rolle **6** abwickelbares Aluminium-Band **7** realisiert ist. Weist das Band **7** eine Schicht der mit dem erfindungsgemäßen Verfahren hergestellten Fullerene **4** auf, wird es auf eine zweite Rolle **8** zur weiteren Bearbeitung aufgewickelt. Die Herstellung der endohedralen Fullerene erfolgt ebenso, wie bereits zu Fig. 1 beschrieben. Das in der Quarzampulle **1** in einem eine Heizung **9** aufweisenden Keramikblock **10**, in Kontakt mit der Anode **11**, angeordnete C₆₀-Material wird verdampft. Durch die gleichzeitig gezündete Hochspannungs-Gasentladung entstehen N⁺-lonen, die mit den Fullerenen wechselwirken. Die entstehende Substanz **4** schlägt sich auf dem gekühlten Teil des Aluminium- Bandes **7** nieder Von Vorteil hierbei ist. daß nach Aufbringen sehr dünner Schichten durch das Aufwickeln des bereits endohedrale Fullerene aufweisenden Teils des Bandes eine Zerstörung dieser vermieden wird. Außerdem wird eine Aufladung der hergestellten endohedralen Fullere vermieden, da der Kontakt zur metallischen Aluminium-Folie **7** erhalten bleibt. Mit der in Fig. 2 dargestellten Ausführungsform der Erfindung kann eine um den Faktor 10 bis 100 effizientere Herstellung der endohedralen Fullerene im Vergleich mit der in Fig. 1 beschriebenen Vorrichtung erreicht werden.

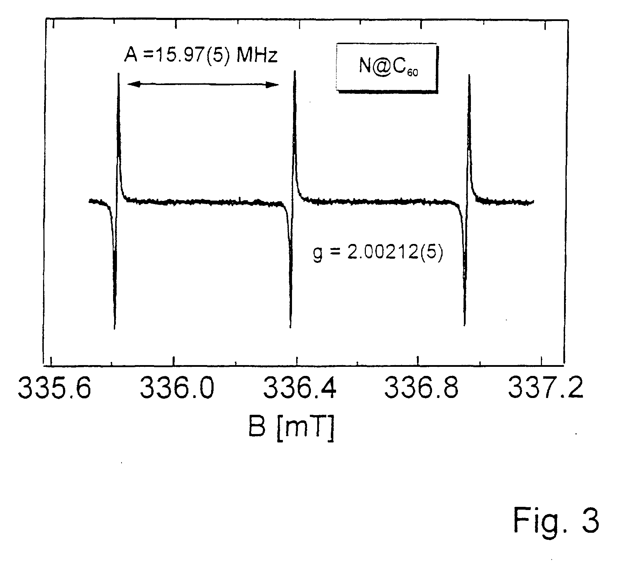

Das in Fig. 3 dargestellte ESR (Electron Spin Resonance)-Spektrum für ¹⁴N@C₆₀ weist sehr scharfe Linien auf. Durch die beiden Parameter A und g (Hyperfeinkonstante A und der g-Faktor) ist dieser Fulleren-Komplex eindeutig bestimmt. Diese Charakteristika treten nur auf, wenn atomarer Stickstoff in der Käfigstruktur des C₆₀-Fullerens eingeschlossen ist. Mit B ist die magnetische Flußdichte bezeichnet.

Weitere Untersuchungen mit ESR und ENDOR (Electron Nuclear Double Resonance) unterstützen die Aussage, daß es sich hierbei um das endohedrale Fulleren N@C₆₀ handelt.

## Patentansprüche

1. Verfahren zur Herstellung von stabilen endohedralen Fulleren der Struktur Z@Cₓ mit x ≥ 60, wobei ein Z-Atom in das Fulleren implantiert wird, indem gleichzeitig in einem Gefäß sowohl Fullerene als auch niederenergetische beschleunigte Z-Teilchen bereitgestellt werden und miteinander wechselwirken, dann diese Fullerene aus dem Gefäß entfernt, in Lösungsmittel gelöst und getrocknet werden,
**dadurch gekennzeichnet, daß**
die Bereitstellung der Fullerene durch Verdampfen von Cₓ in einem von einem das zu implantierende Material enthaltenden Gasgemisch durchströmten Ofen und die Bereitstellung der beschleunigten Z-Teilchen durch eine Hochspannungs-Gasentladung in demselben Ofen erfolgen.

2. Verfahren nach Anspruch 1,
**dadurch gekennzeichnet, daß**
als Z-Atome Atome der Nicht- und Halbmetalle implantiert werden.

3. Verfahren nach Anspruch 2,
**dadurch gekennzeichnet, daß**
als Z-Atome Atome der Elemente C, N. P, O, S, B, Si, Ge und As implantiert werden.

4. Verfahren nach Anspruch 1,
**dadurch gekennzeichnet, daß**
die in die Fullerene Cₓ zu implantierenden Materialien Z in gasförmigen Verbindungen in das Gasentladungsrohr eingebracht werden.

5. Vorrichtung zur Herstellung von stabilen endohedralen Fulleren der Struktur Z@Cₓ mit x ≥ 60 gemäß Anspruch 1 bis 4,
**dadurch gekennzeichnet, daß**
in einem Hochspannungs-Gasentladungs-Ofen (2) eine beheizte Quelle zur Bereitstellung der zu implantierenden Fullerene Cₓ, Mittel, die das Durchströmen des Ofens von einer gasförmigen Verbindung des zu implantierenden Materials Z ermöglichen, sowie Anode und Kathode (5) zur Zündung der Entladung angeordnet sind und die Kathode (5) Mittel zu ihrer Kühlung und/oder eine vergrößerte Fläche aufweist.

6. Vorrichtung nach Anspruch 5,
**dadurch gekennzeichnet, daß**
die vergrößerte Fläche der Kathode (5') als abwickelbares Band (7) ausgebildet und über einen Kühlfinger geführt ist und Mittel zum Aufwickeln (8) des Teiles des Bandes, der mit implantierten Fullerenen (4) der Struktur Z@Cₓ mit x ≥ 60 bedeckt ist, angeordnet sind.

7. Vorrichtung nach Anspruch 5,
**dadurch gekennzeichnet, daß**
die Kathode mit Wasser gekühlt ist.

8. Vorrichtung nach Anspruch 5,
**dadurch gekennzeichnet, daß**
die Kathode mit flüssigem Stickstoff gekühlt ist.

## Claims

1. Method for preparing stable endohedral fullerenes having the structure Z@Cₓ with x ≥ 60, wherein a Z atom is implanted in the fullerene, as a result of the fact that simultaneously both fullerenes and low-energy accelerated Z particles are made available in a vessel and interact with each other, then these fullerenes are removed from the vessel, dissolved in solvent and dried, characterised in that the provision of the fullerenes takes place by evaporation of Cₓ in a furnace through which a gas mixture containing the material to be implanted flows, and the provision of the accelerated Z particles takes place by a high-voltage gas discharge in the same furnace.

2. Method according to claim 1, characterised in that atoms of the non-metals and semi-metals are implanted as Z atoms.

3. Method according to claim 2, characterised in that atoms of the elements C, N, P, O, S, B, Si, Ge and As are implanted as Z atoms.

4. Method according to claim 1, characterised in that the materials Z to be implanted in the fullerenes Cₓ are placed in the gas discharge tube in gaseous compounds.

5. Device for preparing stable endohedral fullerenes having the structure Z@Cₓ with x ≥ 60 in accordance with claims 1 to 4, characterised in that arranged in a high-voltage gas-discharge furnace (2) are a heated source for the provision of the fullerenes Cₓ to be implanted, means which allow a gaseous compound of the material Z to be implanted to flow through the furnace, and also anode and cathode (5) for igniting the discharge, and the cathode (5) has means for its cooling and/or an increased area.

6. Device according to claim 5, characterised in that the increased area of the cathode (5') is constructed as a tape (7) which can be unwound, and is guided by way of a cooling finger, and there are arranged means for unwinding (8) the portion of the tape that is covered with implanted fullerenes (4) having the structure Z@Cₓ with x ≥ 60.

7. Device according to claim 5, characterised in that the cathode is cooled with water.

8. Device according to claim 5, characterised in that the cathode is cooled with liquid nitrogen.

## Revendications

1. Procédé pour la préparation d'un fullerène endoédrique de structure Z@Cₓ avec x ≥ 60, un atome Z étant implanté dans le fullerène, dans lequel on prépare simultanément dans un récipient aussi bien des fullerènes que des particules de Z accélérées à faible énergie et on les soumet à une interaction mutuelle, puis ces fullerènes sont retirés du récipient, dissous dans un solvant et séchés,
caractérisé en ce que
la préparation des fullerènes s'effectue par vaporisation de Cₓ dans un four traversé par un mélange de gaz contenant le matériau à implanter, et la préparation des particules de Z accélérées s'effectue dans le même four par une décharge dans un gaz sous haute tension.

2. Procédé selon la revendication 1,
caractérisé en ce que
des atomes des métalloïdes et des semi-métaux sont implantés en tant qu'atomes Z.

3. Procédé selon la revendication 1,
caractérisé en ce que
des atomes des éléments C, N, P, O, S, B, Si, Ge et As sont implantés en tant qu'atomes Z.

4. Procédé selon la revendication 1,
caractérisé en ce que
les matériaux Z à implanter dans les fullerènes Cₓ sont introduits dans des composés gazeux dans le tube de décharge dans un gaz.

5. Dispositif pour la préparation d'un fullerène endoédrique de structure Z@Cₓ avec x ≥ 60, selon l'une quelconque des revendications 1 à 4,
caractérisé en ce que
dans un four de décharge dans un gaz à haute tension (2), sont disposés une source chauffée pour la préparation des fullerènes Cₓ destinés à recevoir une implantation, des moyens qui permettent la traversée du four par un composé gazeux du matériau Z à implanter, ainsi qu'une anode et une cathode (5) pour l'amorçage de la décharge, et la cathode (5) comporte des moyens pour son refroidissement et/ou une surface agrandie.

6. Dispositif selon la revendication 5,
caractérisé en ce que
la surface agrandie de la cathode (5') se présente sous forme d'une bande (7) pouvant être déroulée et est envoyée sur un cryoplongeur, et des moyens sont disposés pour l'enroulement (8) de la partie de la bande qui est recouverte de fullerènes ayant reçu une implantation (4), de structure Z@Cₓ avec x ≥ 60.

7. Dispositif selon la revendication 5,
caractérisé en ce que
la cathode est refroidie avec de l'eau.

8. Dispositif selon la revendication 5,
caractérisé en ce que
la cathode est refroidie avec de l'azote liquide.
